# EUROPEAN PATENT APPLICATION

(11) **EP 3 667 744 A1**
(43) Date of publication of application: **17.06.2020**
(21) Application number: 18212020.4
(22) Date of filing: 12.12.2018
(51) Int. Cl.: H01L 31/113

(54) **TMDC-BASED OPTOELECTRONIC DEVICE**

(71) Applicant: Humboldt-Universität zu Berlin, 10099 Berlin (DE)
(72) Inventor: Dalgleish, Simon, 12169 Berlin (DE); List-Kratochvil, Emil, 12489 Berlin (DE)
(74) Representative: Hansen, Jochen

(57) **Abstract**

The invention relates to an optoelectronic device comprising a semiconductor channel layer (10) arranged on a dielectric substrate (20), wherein the channel layer (10) consists of at least one monolayer of a transition metal dichalcogenide (TMDC), further comprising at least a source electrode (S) and a drain electrode (D) arranged on the substrate (20) and electrically connected to at least the channel layer (10), further comprising a photosensitizing layer (30) arranged on the channel layer (10), wherein the channel layer (10) is adapted to permit electrical current flow between the electrodes (S, D), wherein electrical conductivity of the channel layer (10) is responsive to the incidence of electromagnetic radiation on the photosensitizing layer (30), wherein the photosensitizing layer (30) is composed of functional dye molecules that exhibit a predetermined local distribution and orientation with respect to the channel layer (10), wherein the functional dye molecules are capable of intra-molecular charge rearrangement under incidence of electromagnetic radiation and provide radiation-responsive molecular electric dipole fields for controlling the conductivity of the channel layer (10).

## Description

The invention relates to an optoelectronic device comprising a semiconductor channel layer arranged on a dielectric substrate, wherein the channel layer consists of at least one monolayer of a transition metal dichalcogenide (TMDC), further comprising at least a source electrode and a drain electrode arranged on the substrate and electrically connected to at least the channel layer, further comprising a photosensitizing layer arranged on the channel layer, wherein the channel layer is adapted to permit electrical current flow between the electrodes, wherein electrical conductivity of the channel layer is responsive to the incidence of electromagnetic radiation on the photosensitizing layer. Such device may produce an electrical output signal in response to incident light and can be used e.g. as a rapid signal coupler between optical and electrical communication networks.

Transition metal dichalcogenides (TMDCs) have been shown to be excellent candidates for next generation electronic and optoelectronic applications since they show strong absorption for visible light and charge carrier mobilities above that of amorphous silicon, even as single monolayer flakes. In contrast to graphene, when taken as monolayers, they show a direct bandgap and, as such, show high on-off ratios in field-effect transistor (FET) devices, meaning that such materials can be successfully employed in switching applications. In such TMDC-based FET devices, the channel conductance in a planar 2-terminal device can be varied over many orders of magnitude through the influence of an electrostatic field generated across a dielectric medium by a 3rd "gate" terminal. Since the active layer can be reduced to a single monolayer, the channel conductance is extremely sensitive to the dielectric medium to which the semiconductor surface is exposed, i.e. adsorbed atoms, molecules or ions affect directly the channel between the source and drain electrodes without screening from a bulk semiconductor overlayer. As such, monolayer TMDC-FETs have been shown to be extremely sensitive to the ambient conditions in which they are measured.

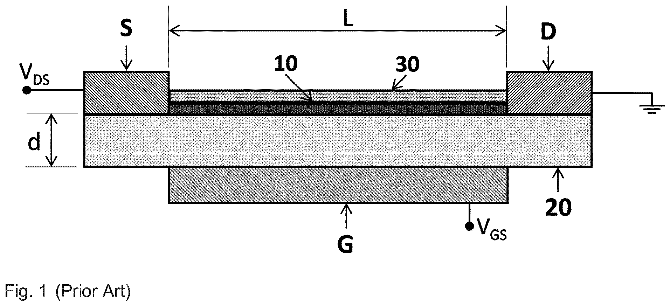

An example of a monolayer TMDC-based detector - e.g. a FET design - is depicted in Figure 1. The optoelectronic device may comprise a continuous monolayer semiconductor (10), e.g. a flake of a TMDC, deposited on an insulating material (20) of thickness d and dielectric constant ε, such that the geometrical capacitance C_{geo} = ε A/d (where A is the overlap area defined between two parallel metallic plate electrodes that sandwich a dielectric in a parallel-plate capacitor). This insulator layer (20) may also serve as gate dielectric which separates the TMDC (10) from a gate electrode (G). The TMDC (10) is directly connected to two electrodes, termed "source" (S) and "drain" (D), of width W, and separated by a length L. It should be noted that the gate electrode (G) has the purpose of tuning the semiconductor (10) conductivity. The gate electrode (G) is a useful but not an obligatory component of the device because the semiconductor (10) conductivity could also be altered by other measures, e.g. by temperature control of the environment.

Also different embodiments of the FET architecture are possible, e.g. where the source (S) and drain (D) electrodes are deposited above or below the semiconductor (10) (top/bottom contact), or where the gate dielectric (20) and gate electrode (G) are deposited onto the semiconductor (10) on an arbitrary insulating substrate (not shown), rather than serving themselves as a substrate (top/bottom gate). All such architectures are suitable for monolayer TMDC-based FETs.

For the sake of simplicity, the operating principle of a monolayer TMDC-based detector shall be explained for the FET design in the following.

FET detectors in general work on the basis of control of free charge carrier density in the semiconductor (10) channel between the source (S) and drain (D) electrodes via a potential difference, V_{GS}, applied between the gate (G) and source (S) electrodes. In the case of an n-type TMDC, such as MoS₂, the application of a positive gate bias draws electrons from the source (S) electrode into the semiconductor (10) channel, resulting in an increase in the conductivity of the semiconductor (10). In the case of a p-type TMDC, such as WSe₂, the application of a negative gate bias draws holes from the source (S) electrode into the semiconductor (10) channel, resulting in a similar increase in conductivity.

In either case, applying a small potential difference, V_{DS}, between the drain (D) and the source (S) electrodes - wherein V_{DS} < V_{GS} - results in an acceleration of free charge carriers towards the drain (D) electrode, resulting in a current I_{DS}. The magnitude of I_{DS} is dependent on the free carrier density and the electric field at the drain (D) - which can be controlled by V_{GS} and V_{DS}, respectively - as well as the mobility of the charge carriers and the channel width of the device. These are constants for pre-known semiconductors and device geometries, respectively. Operating the device at such values of V_{DS} is termed the "linear" regime, where the I_{DS} is linearly dependent on V_{DS}.

If V_{DS} equals V_{GS} then no electric field exist between the drain (D) and gate (G), and the density of free carriers at the drain (D) electrode surface drops to zero. However, the large field between the channel and the drain (D) maintains charge extraction, but further increases in V_{DS} do not significantly increase I_{DS} beyond its value at V_{DS} = V_{GS}. Operating the device at such values of V_{DS} is termed the "saturation" regime, where the I_{DS} remains constant for V_{DS} > V_{GS}.

Important figures of merit for transistors are therefore the field-effect mobility µ and the on/off ratio, since they determine the switching speed and the switching resolution, respectively. Typical values of µ for TMDCs range from 1-1000 cm²/Vs, and on/off ratios can exceed 10⁸. From the above description, the V_{GS} at which carrier accumulation in the channel starts should be zero volts. However, in practice, not all the charges introduced into the channel are free, but can become localized in traps. Conversely, the presence of dopants, introduced either into the semiconductor structure, or adsorbed onto its surface, can provide free carriers to the channel. Depending on the energetics of the traps and dopants, and the device history, the threshold voltage, V_{T}, of V_{GS} at which charge accumulation in the channel starts can be significantly different from zero volts.

Illumination of the FET at energies above the bandgap of the TMDC can also change the conductivity of the channel. For TMDC based phototransistors, the dominant mechanisms of photo-response are based on photoconductive (PC) and photovoltaic (PV) effects.

Photoconductive effects relate to the generation of free carriers following light absorption that increase the conductivity of the channel. Photovoltaic effects relate to a change in V_{T} under illumination due to trapping of minority carriers in the device. Both mechanisms have been identified in TMDC based phototransistors, and device responsivities of more than 10³ A/W have been reported.

However, the slow release/recombination of minority carriers can lead to slow response times, and the occurrence of persistent photoconductivity - wherein the increased conductivity observed under illumination persists long after the light is extinguished. The persistent photoconductivity in TMDC-based phototransistors has been shown to originate principally from charge trapping at potential fluctuations along the semiconductor/dielectric interface, especially for oxide dielectrics where dangling hydroxyl bonds and/or adsorbed water molecules can trap photo-generated holes, resulting in a large negative shift in V_{T} that persists for hours after illumination is extinguished. Various strategies have been explored to reduce the extent of charge trapping in TMDCs, including passivation of the dielectric/TMDC interface with e.g. self-assembled monolayers or hydroxyl-free dielectrics, or through specific surface functionalization with e.g. graphene oxide, or by healing of the defects in TMDC structure.

While the persistent photoconductivities and other hysteretic effects in TMDC devices are clearly undesirable, they emphasize the extreme sensitivity of the TMDC monolayers to small potential changes at their surfaces. Several efforts to exploit that sensitivity for sensor applications are already known:
For example, the paper of D.M. Sim et al. (ACS Nano, 2015, 9, 12115-12123) presents a method to tune the conductance in planar 2- and 3-terminal devices of monolayer MoS₂ based on the covalent binding of thiol-based molecules at sulfur vacancies that exist as defects in the MoS₂ structure. By varying the end group of the thiol between electron rich and electron poor groups, it is possible to modify the carrier density in the MoS₂, and thereby the threshold voltage of charge accumulation in the device in a controlled and permanent manner.

A work in the field of bio-sensors has been disclosed in US 2017/0102357 A1 whereby the channel conductivity in a planar TMDC based device is sensitive to the binding events of antigens to antibodies attached directly to the channel, which affects the potential energy profile across the TMDC. The method of US 2017/0102357 A1 is a bi-molecular process designed to measure the concentration of a first molecule species in a fluid flow by functionalizing the TMDC surface with a second molecule species. Such a sensor is certainly dependent on the presence of the first molecular species in the fluid flow and probably not reversible to its initial state because par. 0054 of US 2017/0102357 A1 points out that about 30 % of bound antigen molecules remain adsorbed on the sensor even after a long rinsing process.

US 2016/0020352 A1 describes a TMDC optoelectronic device where the wavelength range of light absorption is extended through the use of quantum dots (QDs) in a photosensitizing layer (30) on top of the semiconductor layer (10), see again Figure 1 representing the prior art. Quantum dots can absorb light of wavelengths in the near infrared and can transfer the photo-generated charges to the TMDC, thereby increasing the channel conductivity. However, such a method relies on the correct energy level alignment for the QDs such that they can transfer their charge to TMDC, as well as consideration of the transit time of injected carriers through the TMDC relative to the trapping lifetime of the carriers in the QD since these values directly affect the sensitivity of the device.

It is the objective of the invention to propose an optoelectronic device with an enhanced wavelength range of detection and which overcomes several deficiencies of the prior art.

The objective is achieved by an optoelectronic device comprising a semiconductor channel layer (10) arranged on a dielectric substrate (20), wherein the channel layer (10) consists of at least one monolayer of a transition metal dichalcogenide (TMDC), further comprising at least a source electrode (S) and a drain electrode (D) arranged on the substrate (20) and electrically connected to at least the channel layer (10), further comprising a photosensitizing layer (30) arranged on the channel layer (10), wherein the channel layer (10) is adapted to permit electrical current flow between the electrodes (S, D), wherein electrical conductivity of the channel layer (10) is responsive to the incidence of electromagnetic radiation on the photosensitizing layer (30), characterized in that the photosensitizing layer (30) is composed of functional dye molecules that exhibit a predetermined local distribution and orientation with respect to the channel layer (10), wherein the functional dye molecules are capable of intra-molecular charge rearrangement under incidence of electromagnetic radiation and provide radiation-responsive molecular electric dipole fields for controlling the conductivity of the channel layer (10). Further claims are directed to advantageous embodiments of the optoelectronic device.

At the very core of the presented invention is the idea that the functional dye, itself, brings about a change in the potential profile across the TMDC by electrical interaction of the molecular electric dipole field with the semiconductor channel layer (10). There is no charge transfer involved and, hence, no energy level considerations for electron transitions and no trapping of injected charges within the semiconductor. Instead, the superposition of the collective of functional dye molecular fields arranged in a photosensitizing layer (30) on and along the - in most cases monolayer - semiconductor channel layer (10) acts on the semiconductor's band structure to alter the amount of conduction band electrons.

Effectively, the invention shifts the response time of the invented optoelectronic device towards the functional dye's excitation/relaxation time constants after activating or extinguishing an exciting light source. For example, solvatochromic dye molecules show a change in their dipole moment upon photoexcitation that reverts as the excitation source is extinguished, on a timescale correlated with the electronic excitation/relaxation process which can be less than 1 nanosecond.

Solvatochromic dye molecules are a preferred choice for the functional dyes, e.g. to develop a fast photo-response based on high charge-carrier mobility of some TMDC, because their photoexcitation yields a fast and oriented change to their molecular dipole. Such dyes that efficiently absorb electromagnetic radiation in the NIR spectral range are particularly suitable since this range is especially relevant for optical communications application, since it is the region most transparent for silica fibre optic networks.

Since the superposition of the collective of molecular fields of functional dyes is the quantity "seen" by the semiconductor channel layer (10) in this invention, it is of great importance that the functional dyes exhibit a predetermined local distribution and orientation with respect to the channel layer (10). If they were disordered or randomly distributed along the channel layer (10) then the superposition field could be subject to internal cancellation and ambiguity and would not provide a reliable measure of incident radiation intensity.

Therefore, it is a preferred embodiment that the functional dye molecules of the photosensitizing layer (30) have anchor groups that can bind covalently to the channel layer (10) surface. Moreover, since transition metal dichalcogenides are well-known to exhibit chalcogenide vacancies at their surfaces, especially on monolayer TMDC flakes, the anchor groups should preferably be capable to bind covalently to such chalcogenide vacancies. Whereas a variety of TMDC materials including, but not limited to MoS₂, MoSe₂, WS₂, WSe₂ or combinations thereof, are suitable to build optoelectronic devices in accord with this description, those that form vacancies into which thiol- and/or disulfide-groups can bind are advantageous since these are preferred anchor groups due to their ease of formation, high stability and low toxicity.

Binding functional dye molecules with anchor groups may be achieved by several processes known in the art, e.g. bath coating, vapor coating or spin coating, followed by a post-processing step to remove non-specifically bound, and thus non-oriented, dye species, such as by extensive washing, or thermal treatment. As the functional dye can only bind covalently with its anchor nearest to the TMDC, the common orientation of all bonded dye molecules relative to the channel layer (10) is assured.

Regarding the dielectric substrate (20), the material may be chosen from a large variety including, but not limited to oxide dielectrics (SiO₂, Al₂O₃, HfO₂, etc.), inorganic dielectrics (hexagonal boron nitride (hBN), etc.) organic dielectrics (polystyrene, polymethylmethacrylate, parylene, benzocyclobutene-based polymers, etc.), self-assembled molecular dielectrics (thiols, silanes, phosphonic acids, etc.), electrolyte dielectrics (electrolyte solutions, ionic liquids/gels, etc.) or combinations thereof. Suitable electrically conducting materials for the electrodes (S, D, optionally also G) include but are not limited to common elemental metals (Au, Ag, Pt, In, etc.), organic metals (tetrathiafulvalene 7,7,8,8-tetracyanoquinodimethane salt (TTF-TCNQ), etc.) and metal oxides (indium tin oxide (ITO), aluminium zinc oxide (AZO), fluorine doped tin oxide (FTO), etc.).

The invention shall be explained in further detail and illustrated by attached figures.
- Fig. 1: shows a sketch of an optoelectronic TMDC-FET device (prior art);
- Fig. 2: presents a draft of a TMDC monolayer (10) with chalcogenide vacancies (V) and a functional (solvatochromic) dye molecule (30) with disulfide-group as anchor;
- Fig. 3: shows a normalized plot of device responsivity vs. wavelength of incident light for an exemplary MoS₂ optoelectronic FET device with (10 + 30; dashed line) and without (10; solid line) a photosensitizing layer on top of the MoS₂ channel layer, as depicted in Figure 2.

As explained above, the main idea of the invention is to couple the dynamical photo-response of the optoelectronic device to collective changes in dipole moments of molecules in the photosensitizing layer on the surface of the semiconductor channel layer. Therefore, time constants for excitation and relaxation of photo-excited molecules represent a further degree of freedom for photo-sensor devices.

In a preferred embodiment the functional dye in the photosensitizing layer (30) is selected such that the radiation-responsive molecular electric dipole fields impart a transient change to the channel layer (10) conductivity under incidence of electromagnetic radiation. Transient change means in this context that the conductivity is at least continuous - preferably even more or less proportional - with light intensity per time unit incident on the photosensitizing layer (30). Ideally, the conductivity should return to its value before illumination almost immediately after the light is extinguished.

It is a further preferred embodiment that the functional dye molecules show an absorption in the wavelength range 800-1600 nm, even more preferably the functional dye being a solvatochromic dye selected from the group containing: heteroleptic metal bis-dithiolenes, metal(diimine)(dithiolenes) and asymmetric squaraines.

At least one optoelectronic device exhibiting transient conductivity change of the channel layer (10) controlled by a photosensitizing layer (30) containing a NIR-responsive functional dye may serve as a key component of an optoelectronic signal coupler adapted to convert free-space or fiber-guided light signals in the wavelength range 800 -1600 nm to electric signals. Signals in this context are time-dependent physical quantities like light intensity and electric current and the information they may carry within their temporal modulation.

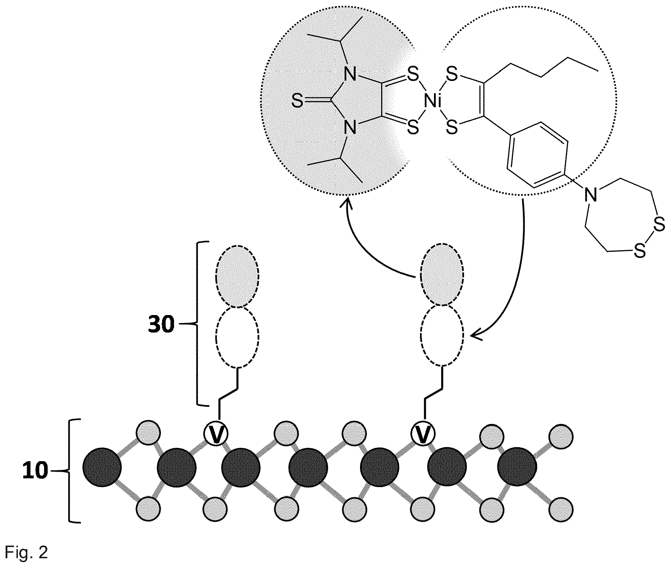

As a proof-of-concept experiment and as an example for an optoelectronic device in accordance with the invention, several FET architecture phototransistors comprising MoS₂ channel layers sensitized with a near-infrared (NIR) solvatochromic dye, namely a heteroleptic nickel bis-dithiolene as depicted in Figure 2, by covalent attachment to sulfur vacancies on the MoS₂ surface are fabricated.

In order to accurately assess the effect of functional dye modification on the photodetector response, a robust testing platform was developed that utilized large-area CVD grown continuous MoS₂ monolayers transferred to long channel length (>30 µm) bottom-contact bottom-gate (BCBG) Si/SiO₂ transistor substrates. The BCBG architecture was used to ensure consistent channel dimensions for the devices, and to avoid possible damage to the monolayer induced by the shadow mask used for top contact electrode deposition. In order to avoid significant strain in the MoS₂ at the contacts, ultra-thin source/drain electrodes were developed and used comprising a 9 nm Au film adhered to the substrate using a mixed self-assembled monolayer of amine and thiol terminated silane self-assembled monolayers (SAMs) as an adhesion layer. Transfer was achieved using an established method that results in minimal chemical impurities on the MoS₂ after transfer, and the as-fabricated devices showed typical n-type characteristics, with negligible contact resistance and with field-effect mobilities of the order 5 cm²/Vs, which is comparable to literature values for CVD-grown large area flakes.

Dye sensitization was carried out following a thermal annealing step to generate sulfur vacancies by soaking the film in a solution of the dye, followed by extensive rinsing with clean solvent. The covalent attachment of dye molecule at the surface of the MoS₂ was confirmed by X-ray photoelectron spectroscopy which showed the presence of nickel and nitrogen atoms on the MoS₂ surface following sensitization.

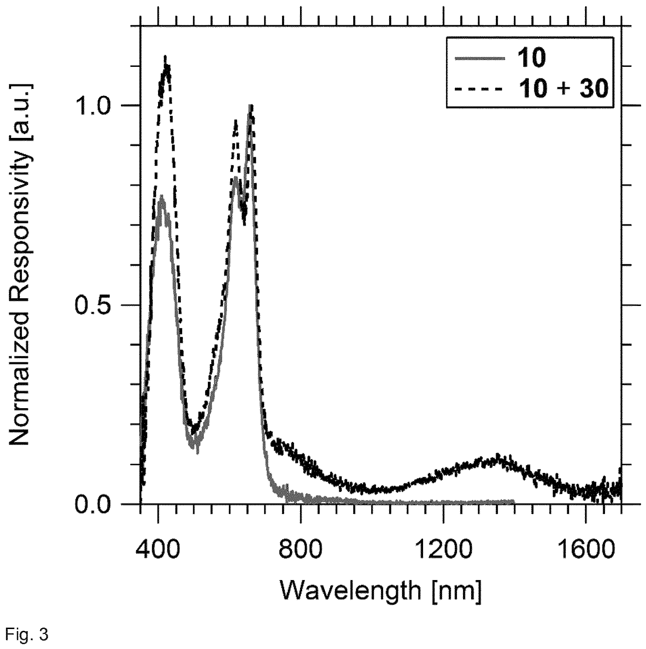

Figure 3 shows the wavelength-dependent responsivity spectrum of an as-deposited MoS₂ phototransistor (10, 20), compared to a device sensitized with the solvatochromic dye photosensitizing layer (30). Compared to the as-deposited MoS₂ phototransistors, which show a wavelength cut-off of detection at λ < 700 nm (1.77 eV), the sensitized devices show an additional clear photoresponse centred around 1300 nm (0.95 eV). The three distinct peaks in the as-deposited spectrum correspond to the three absorption bands in the MoS₂ absorption spectrum, and are identified as the A, B and C excitonic transitions. While the relative intensities of these three peaks are changed in the photosensitized device spectrum, these changes are consistent with changes induced only by the thermal annealing step without SAM formation. The peak at 1300 nm, however, was not present in the annealed devices, and has only been observed for devices that underwent photosensitization with a layer of solvatochromic dye.

The measurements in Figure 3 prove that MoS₂ can be sensitized with functional dipolar dye molecules through covalent thiol binding to sulfur vacancies, and can extend the responsivity range of MoS₂ photodetectors well into the NIR range.

As already mentioned, the time constants for excitation and relaxation of photo-excited molecules with radiation-responsive dipole moment are important to control the dynamic behavior of the optoelectronic device of this invention. One may consider the case that these time constants may be very much longer than any time interval of illumination of the device. If so, then the light seen by the detector would create a persistent state of channel conductivity, and the measured data could be read out electrically at any later time - and even repeatedly. Such an optoelectric device would represent an optoelectronic memory or data storage.

Fortunately, photochromic dye molecules show a reversible transformation between two forms by the absorption of electromagnetic radiation (photoisomerization). A photochromic molecule may deform or bend under incidence of light of a predetermined wavelength into a different configuration - which typically also affects the intra-molecular charge distribution - and remains in that state unless illuminated with light of another wavelength to reverse the deformation. Such molecules are generally termed bi-stable. Some photochromic molecules may also be "switched" thermally from one state to the other. Photochromism is employed e.g. to construct molecular machines.

It is a preferred embodiment of the optoelectronic device of the invention to comprise a photosensitization layer (30) imposing radiation-responsive molecular electric dipole fields that impart a persistent change to the channel layer (10) conductivity under incidence of electromagnetic radiation.

It is a further preferred embodiment if the photosensitizing layer (30) exhibits functional dye molecules that are photo- and/or thermally reversible photochromic dye molecules, even more preferably the photochromic dye being selected from the group containing: azobenzenes, diarylethenes and spiropyrans.

An advantageous optoelectronic memory device may comprise at least one optoelectronic device of the invention wherein the optoelectronic memory device is adapted to memorize a light intensity incident for a predetermined time interval on the photosensitizing layer (30) wherein a persistent change of channel layer (10) conductivity is electrically measurable after the time interval of light incidence.

It is noteworthy that a tiny and localized channel layer (10) of a single optoelectronic device in accordance with the invention can be seen as a single pixel of an electronic camera. A two-dimensional array plane of such pixels is suitable to detect and to store any light intensity distribution across the array. The memorized light distribution may be, for example, a conventional picture - taken with an objective lens - or an interferogramm from direct illumination with probe and reference light. In any case, the memorized image is read out electrically and can be forwarded to a conventional computer for further work and evaluation.

For that reason, an optoelectronic memory device comprising a multitude of optoelectronic devices arranged in an array plane wherein the optical memory device is adapted to memorize a light intensity distribution across the multitude of channel layers (10) in the array plane wherein an image is electrically readable after the time of imaging the light intensity distribution is an advantageous alternative or even a possible substitute for a CCD camera of the prior art.

## Claims

1. An optoelectronic device comprising a semiconductor channel layer (10) arranged on a dielectric substrate (20), wherein the channel layer (10) consists of at least one monolayer of a transition metal dichalcogenide (TMDC), further comprising at least a source electrode (S) and a drain electrode (D) arranged on the substrate (20) and electrically connected to at least the channel layer (10), further comprising a photosensitizing layer (30) arranged on the channel layer (10), wherein the channel layer (10) is adapted to permit electrical current flow between the electrodes (S, D), wherein electrical conductivity of the channel layer (10) is responsive to the incidence of electromagnetic radiation on the photosensitizing layer (30),
**characterized in that**
the photosensitizing layer (30) is composed of functional dye molecules that exhibit a predetermined local distribution and orientation with respect to the channel layer (10), wherein the functional dye molecules are capable of intra-molecular charge rearrangement under incidence of electromagnetic radiation and provide radiation-responsive molecular electric dipole fields for controlling the conductivity of the channel layer (10).

2. The optoelectronic device of claim 1 comprising a gate electrode (G) arranged along the channel layer (10) wherein the gate electrode (G) is electrically isolated from the channel layer (10) by a gate dielectric.

3. The optoelectronic device of claim 2 wherein the gate electrode (10) is arranged on the backside of the substrate (20) with the substrate (20) being the gate dielectric.

4. The optoelectronic device of any of the preceding claims wherein the functional dye molecules of the photosensitizing layer (30) have anchor groups that can bind covalently to the channel layer (10) surface.

5. The optoelectronic device of claim 4 wherein the anchor groups bind covalently to chalcogenide vacancies.

6. The optoelectronic device of claim 5 wherein the anchor groups are thiol- and/or disulfide-groups.

7. The optoelectronic device of any of the preceding claims wherein the radiation-responsive molecular electric dipole fields impart a transient change to the channel layer (10) conductivity under incidence of electromagnetic radiation.

8. The optoelectronic device of any of claims 1 through 6 wherein the radiation-responsive molecular electric dipole fields impart a persistent change to the channel layer (10) conductivity under incidence of electromagnetic radiation.

9. The optoelectronic device of claim 7 wherein the functional dye molecules show an absorption in the wavelength range 800-1600 nm, preferably the functional dye is a solvatochromic dye selected from the group containing: heteroleptic metal bis-dithiolenes, metal(diimine)(dithiolenes) and asymmetric squaraines.

10. The optoelectronic device of claim 8 wherein the functional dye molecules are photo- and/or thermally reversible photochromic dye molecules, preferably at least one selected from the group containing: azobenzenes, diarylethenes and spiropyrans.

11. Optoelectronic signal coupler comprising at least one optoelectronic device of claim 9 adapted to convert free-space or fiber-guided light signals in the wavelength range 800 - 1600 nm to electric signals.

12. Optoelectronic memory device comprising at least one optoelectronic device of claim 10 wherein the optoelectronic memory device is adapted to memorize a light intensity incident for a predetermined time interval on the photosensitizing layer (30) wherein a persistent change of channel layer (10) conductivity is electrically measurable after the time interval of light incidence.

13. Optoelectronic memory device comprising a multitude of optoelectronic devices of claim 10 arranged in an array plane wherein the optical memory device is adapted to memorize a light intensity distribution across the multitude of channel layers (10) in the array plane wherein an image is electrically readable after the time of imaging the light intensity distribution.
